# EUROPEAN PATENT APPLICATION

(11) **EP 4 687 391 A1**
(43) Date of publication of application: **04.02.2026**
(21) Application number: 25193322.2
(22) Date of filing: 01.08.2025
(51) Int. Cl.: H05K 7/20

(54) **HIGH PERFORMANCE REDUNDANT LIQUID COOLING FOR POWER MODULES**

(30) Priority: 02.08.2024 US 202418793039
(71) Applicant: Lockheed Martin Corporation, Bethesda, Maryland 20817 (US)
(72) Inventor: Gurpinar, Emre, Stratford, CT 06615 (US)
(74) Representative: Schmitt-Nilson Schraud Waibel Wohlfrom Patentanwälte Partnerschaft mbB

(57) **Abstract**

A power converter system for use in an aircraft includes a plurality of power converter module assemblies and a cooling system. Each power converter module assembly of the plurality of power converter module assemblies includes a semiconductor package, a first flow manifold, and a second flow manifold. The semiconductor package defines a heat transfer surface. The first flow manifold and the second flow manifold are thermally coupled to the heat transfer surface. The cooling system includes a first flow circuit and a second flow circuit. The first flow circuit is fluidly coupled in series flow arrangement to the first flow manifold of each of the plurality of power converter module assemblies. The second flow circuit is fluidly coupled to the second flow manifold of each of the plurality of power converter module assemblies.

## Description

The present disclosure relates generally to the field of cooling systems for power modules assemblies used in power converters.

Power converters are used in various vehicle and aircraft systems to convert electrical power from one form to another, such as between alternating current (AC) and direct current (DC). For example, AC power may be used in the aircraft's primary power system, while DC may be used to power specific components of the aircraft's control system (e.g., avionics systems, etc.). Such power converters generally include semiconductor power modules which require high performance liquid cooling systems to extract the heat generated in power semiconductor packages.

One aspect of the present disclosure relates to a power converter system. The power converter system includes a plurality of power converter modules and a cooling system. Each power converter module of the plurality of power converter modules includes a semiconductor package, a first flow manifold, and a second flow manifold. The semiconductor package defines a heat transfer surface. The first flow manifold and the second flow manifold are thermally coupled to the heat transfer surface. The cooling system includes a first flow circuit and a second flow circuit. The first flow circuit is fluidly coupled in series flow arrangement to the first flow manifold of each of the plurality of power converter modules. The second flow circuit is fluidly coupled to the second flow manifold of each of the plurality of power converter modules.

Another aspect of the present disclosure relates to a power converter system including a power converter module assembly, a first flow circuit, and a second flow circuit. The power converter module assembly includes a semiconductor package, a microchannel structure, a first flow manifold, and a second flow manifold. The semiconductor package defines a heat transfer surface. The microchannel structure is coupled to the heat transfer surface. The first flow manifold is fluidly coupled to the microchannel structure. The second flow manifold is fluidly coupled to the microchannel structure in parallel flow arrangement with the first flow manifold. The first flow circuit is fluidly coupled to the first flow manifold. The second flow circuit is fluidly coupled to the second flow manifold.

Yet another aspect of the present disclosure relates to a method of making a power converter system. The method includes providing a first power converter module assembly having a semiconductor package, a microchannel structure, a first flow manifold, and a second flow manifold. The microchannel structure is coupled to the semiconductor package. The first flow manifold is coupled to the microchannel structure. The second flow manifold is coupled to the microchannel structure in a parallel flow arrangement with the first flow manifold. The method includes fluidly coupling a first flow circuit to the first flow manifold. The method further includes fluidly coupling a second flow circuit to the second flow manifold.

This summary is illustrative only and should not be regarded as limiting.

The disclosure will become more fully understood from the following detailed description, taken in conjunction with the accompanying figures, wherein like reference numerals refer to like elements, in which:
FIG. 1 is a top view of power converter system inclusive of a cooling system for multiple power converter modules, according to an embodiment.
FIG. 2 is a perspective view of a half portion of a single power converter module assembly that may be used in the cooling system of FIG. 1, according to an embodiment.
FIG. 3 is a front view of the power converter module assembly of FIG. 2.
FIG 4 is a side view of the power converter module assembly of FIG. 2.
FIG. 5A is another side view of the power converter module assembly of FIG. 2
FIG. 5B is a side view of a switch portion of the power converter module assembly of FIG. 5A.
FIG. 6 is a perspective view of a cooling assembly for a power converter module assembly that includes multiple flow manifolds, according to an embodiment.
FIG. 7 is a flow diagram of a method of making a power converter system, according to an embodiment.

In the following detailed description, reference is made to the accompanying drawings, which form a part hereof. In the drawings, similar symbols typically identify similar components, unless context dictates otherwise. The illustrative embodiments described in the detailed description, drawings, and claims are not meant to be limiting. Other embodiments may be utilized, and other changes may be made, without departing from the spirit or scope of the subject matter presented here. It will be readily understood that the aspects of the present disclosure, as generally described herein, and illustrated in the figures, can be arranged, substituted, combined, and designed in a wide variety of different configurations, all of which are explicitly contemplated and made part of this disclosure.

Semiconductor power modules used in power converters require high performance liquid cooling systems to extract the heat generated in power semiconductor packages. In power critical applications, such as aircraft applications, redundant power converter modules may be required to reduce failure rates to acceptable levels and/or based on federal regulations and/or application-specific requirements (e.g., to 10⁻⁹ mean time between failures for aircraft applications, etc.). In such instances, each power converter may include its own cooling system, with its own individual cooling lines and a liquid pump. Such redundancy also ensures that at least one power converter remains operational in the event of a failure of any one of the cooling systems.

Embodiments of the present disclosure relate to cooling systems and methods for cooling multiple power converters simultaneously while also providing operational redundancy. In at least one embodiment, the cooling system includes two flow circuits (e.g., cooling lines, etc.) that are shared between multiple power converters. The flow circuits are arranged in a parallel flow arrangement along the individual power converter module assemblies within each power converter so that each individual power converter module assembly is cooled by both flow circuits simultaneously. Each power converter module assembly includes at least two microchannel systems guided with manifolds that are running in parallel with one another.

In some embodiments, each of the two flow circuits are connected in a series flow arrangement across the power converters. More specifically, a first flow circuit is fluidly coupled in a series flow arrangement to the first flow manifold and a first microchannel system of each of the plurality of power module assemblies, and a second flow circuit is fluidly coupled in a series flow arrangement to the second flow manifold and a second microchannel system of each of the plurality of power converter module assemblies. The use of the microchannel and manifold system for each power converter module assembly within each power converter reduces system complexity, and can provide weight savings by eliminating the need for separate flow lines and/or pumps for each individual power converter. The cooling system (e.g., the two circuits) may be connected in series or in parallel between power converter module assemblies and/or the power converters in various embodiments.

The power converter system also includes cooling hardware that is structured to increase overall cooling performance for the power converter module assemblies within each power converter. For example, a cooling assembly for each power converter module assembly may include a pair of flow manifolds arranged in a parallel flow arrangement. In some embodiments, the flow manifolds are coupled to a microchannel structure defining substantially parallel flow channels that extend parallel to one another along the length of the power converter module. Such an arrangement can enable continued operation of each of the power converters at greater than half its rated power without having to deactivate any of the power converters, as will be further described.

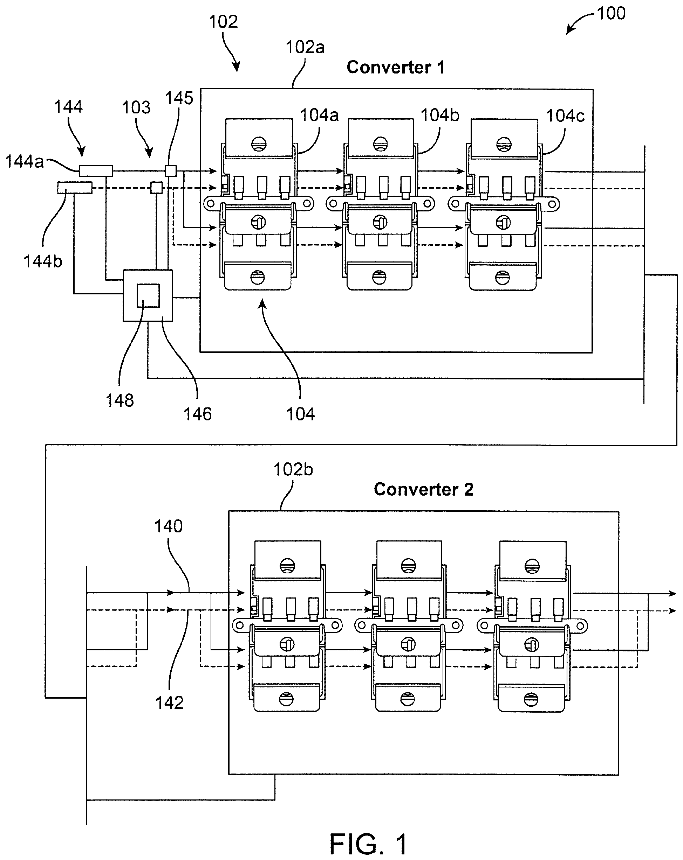

Referring to FIG. 1, a power converter system 100 is shown, according to an embodiment. In some embodiments, the power converter system 100 is configured for use in an aircraft application, such as to provide AC/DC switching for various systems onboard the aircraft. The power converter system 100 may also be used in other applications, such as in motor vehicle applications and/or for stationary or non-stationary generator applications that are configured to produce electrical power.

The power converter system 100 includes a plurality of power converters 102 and a cooling system 103. In the embodiment of FIG. 1, the plurality of power converters includes a pair of power converters, including a first power converter 102a and a second power converter 102b. In other embodiments, the power converter system 100 may include additional power converters (e.g., three power converters for a single cell for an aircraft application, and where the aircraft further includes multiple cells to provide triple redundancy during operation, etc.).

Additionally, each of the first power converter 102a and the second power converter 102b includes a plurality of power converter module assemblies 104. For example, in the embodiment of FIG. 1, the first power converter 102a includes three separate power converter module assemblies, including a first converter module assembly 104a, a second converter module assembly 104b, and a third power converter module assembly 104c. In other embodiments, each power converter may include additional or fewer power converter module assemblies.

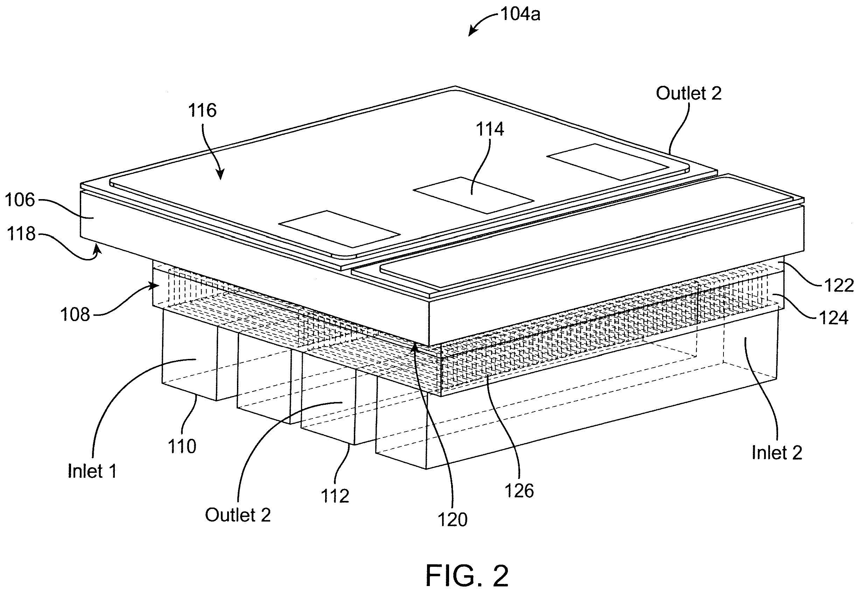

Referring to FIGS. 2-4, the first converter module assembly 104a includes a power converter module having a semiconductor package 106 including a die, a microchannel structure 108. The first converter module assembly also includes a cooling subassembly (e.g., cooling hardware, etc.), including a first flow manifold 110, and a second flow manifold 112. The first converter module assembly 104a (e.g., the power converter module, etc.) also includes switching components including at least one first switch 114 and at least one second switch. In the embodiment of FIGS. 2-4, the first switch 114 is disposed on a first side 116 of the semiconductor package 106 and the microchannel structure 108, the first flow manifold 110, and the second flow manifold 112 are coupled to a second side 118 of the semiconductor package 106 opposite the first side 116.

The semiconductor package 106 (e.g., semiconductor chip, etc.) provides a support structure for various components of the first converter module assembly 104a, including the first switch 114 and the second switch. The semiconductor package 106 also supports wire traces, leads, and/or electrical connections for the electrical components of the first converter module assembly 104a. In some embodiments, the semiconductor package 106 includes a die made from silicon (e.g., a silicon wafer, etc.). In the embodiment of FIGS. 2-3, the semiconductor package 106 defines a heat transfer surface 120 on the second side that is aligned with the first switch 114.

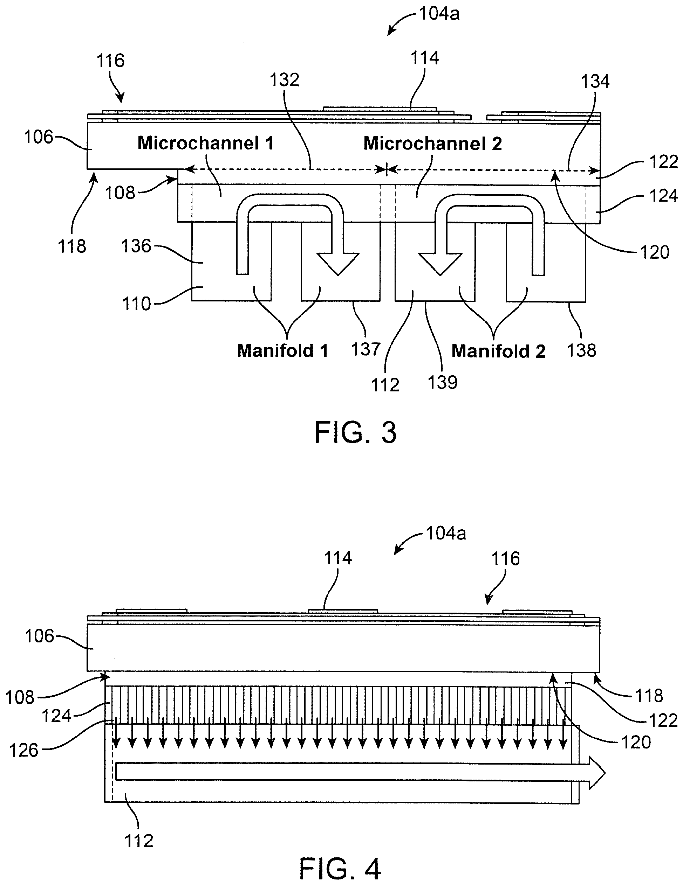

In some embodiments, the microchannel structure 108, the first flow manifold 110, and the second flow manifold 112 together form a cooling assembly for the first converter module assembly 104a. Referring to FIG. 2 and FIG. 4, the microchannel structure 108 is directly coupled to the heat transfer surface 120 and extends across the heat transfer surface 120. The microchannel structure 108 includes a base 122 and plurality of channel members 124 extending away from the base 122. The channel members 124 are elongated rectangular protrusions that are arranged perpendicular to the base 122. The channel members 124 are oriented substantially parallel to one another. The channel members 124 define a plurality of substantially parallel microchannels 126 (e.g., grooves, slots, recessed areas, etc.) that extend across the base 122.

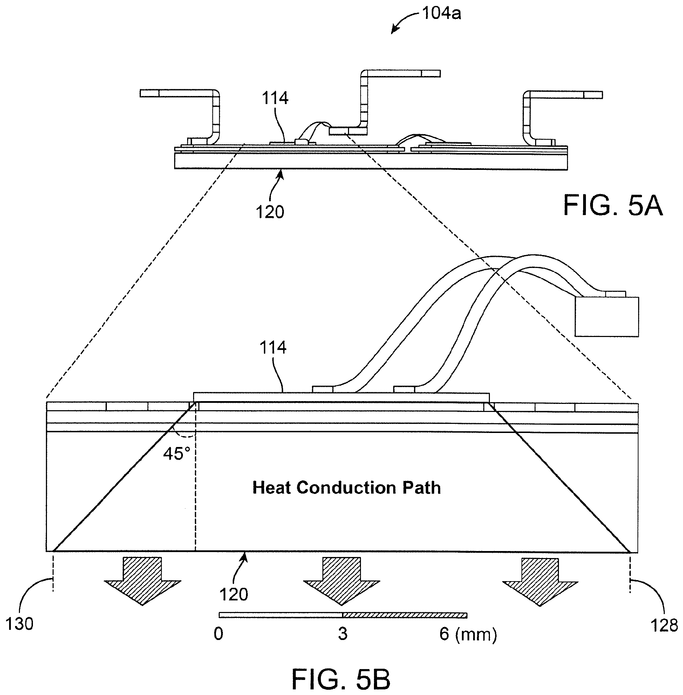

Referring to FIGS. 5A-5B, in some embodiments, the microchannel structure 108 (see also FIG. 2) is centered with respect to the first switch 114 along the heat transfer surface 120. For example, the microchannel structure 108 may extend from a first end 128 of a heat conduction path along the heat transfer surface 120 to a second end 130 of the heat conduction path opposite the first end 128. In some embodiments, as shown in FIG. 5B, the heat conduction path is defined by a 45° spreading angle from outer ends of the first switch 114.

Referring again to FIGS. 2-4, the first flow manifold 110 and the second flow manifold 112 are each thermally coupled to the heat transfer surface by the microchannel structure 108. In some embodiments, the second flow manifold 112 is coupled to the microchannel structure 108 in parallel flow arrangement with the first flow manifold 110. In at least one embodiment, the first flow manifold 110 and/or the second flow manifold 112 include a manifold divider that is extends perpendicular to the channel members 124, between a first longitudinal end and a second longitudinal end of the microchannel structure 108. The manifold divider may be structured to cause liquid coolant to flow through at least a portion of each of the parallel microchannels 126 (e.g., between opposing ends of the manifold divider) between opposing lateral ends/sides of the manifold divider.

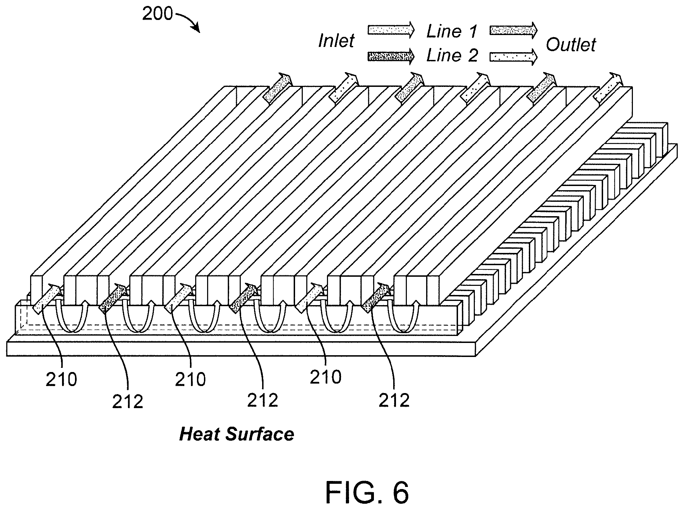

In some embodiments, the first flow manifold 110 is one of a plurality of first flow manifolds (e.g., a plurality of first flow dividers) coupled to the heat transfer surface 120, and/or the second flow manifold 112 is one of a plurality of second flow manifolds (e.g., a plurality of second flow dividers) coupled to the heat transfer surface. For example, referring to FIG. 6, a cooling assembly 200 for a power converter module is shown having a plurality of first flow manifolds 210 and a plurality of second flow manifolds 212. The first flow manifolds 210 and the second flow manifolds 212 are each arranged in parallel flow arrangement across the microchannel structure. Such an arrangement can improve flow uniformity and can improve heat transfer from the semiconductor package in certain applications.

Referring again to FIG. 3, the first flow manifold 110 and the second flow manifold 112 are fluidly coupled to the microchannel structure (e.g., the channel members 124, etc.) and are configured to guide flow of a coolant into the microchannels in a uniform manner. In some embodiments, at least a portion of the first flow manifold 110 and/or the second flow manifold 112 may be integrally formed with microchannel structure 108, such as via an etching operation.

In some embodiments, the first flow manifold 110 is fluidly isolated from the second flow manifold 112 by the microchannel structure 108. For example, the microchannel structure 108 may include a partition approximately halfway between opposing ends of the microchannel structure 108. In other embodiments, the microchannel structure 108 is formed in two separate sections, including a first microchannel structure coupled to the first flow manifold 110 and a second microchannel structure coupled to the second flow manifold 112.

In some embodiments, the first flow manifold 110 and the second flow manifold 112 occupy substantially equal portions of the microchannel structure 108. For example, the first flow manifold 110 may be centered with respect to a first half portion 132 of the semiconductor package 106 (e.g., the microchannel structure 108, the heat transfer surface 120, etc.) and the second flow manifold 112 may be centered with respect to a second half portion 134 of the semiconductor package 106 that is approximately equal in size (e.g., a length, a width, etc.) to the first half portion 132.

The first flow manifold 110 defines a first fluid inlet 136 and first fluid outlet 137 for a first flow circuit through the first converter module assembly 104a. The second flow manifold 112 defines a second fluid inlet 138 and a second fluid outlet 139 for a second flow circuit through the first converter module assembly 104a. The flow path through the first arranged in parallel with the first flow circuit.

Referring to FIG. 3, in some embodiments, the inlets and the outlets of the first flow manifold 110 and the second flow manifold 112 are arranged so that liquid coolant flows along the microchannel structure 108 (e.g., along the parallel microchannels 126) toward a plane of symmetry between the first flow manifold 110 and the second flow manifold 112. Such an arrangement can improve cooling in some applications by imposing the greatest temperature different along the outer ends of the heat conduction path. In other embodiments, the inlets and the outlets of first flow manifold 110 and the second flow manifold 112 are arranged so that liquid flows in the same direction along the microchannel structure 108, which can provide a more uniform temperature difference across the heat transfer surface 120. In some embodiments, the first converter module assembly 104a includes headers, and/or other fluid flow connections for the first flow manifold 110 that are separate from the first flow manifold 110.

In some embodiments, each of the first converter module assembly 104a, the second converter module assembly 104b, and the third power converter module assembly 104c are identical to one another.

Referring again to FIG. 1, the cooling system 103 is configured to control the flow of liquid coolant to the power converters 102 and to direct the flow of liquid coolant between the power converters 102. The cooling system 103 includes a first flow circuit 140, a second flow circuit 142, at least one fluid driver 144, at least one sensor 145, and a cooling control module 146. In other embodiments, the cooling system 103 may include additional, fewer, and/or different components.

The first flow circuit 140 and the second flow circuit 142 are structured to fluidly couple the power converters 102 to one another. In the embodiment of FIG. 1, the first flow circuit 140 is fluidly coupled in series flow arrangement to the first flow manifold 110 of each of the plurality of power converter module assemblies 104. The second flow circuit 142 is fluidly coupled in series flow arrangement to the second flow manifold 112 of each of the plurality of power converter module assemblies 104. Each of the first flow circuit 140 and the second flow circuit 142 includes a plurality of fluid conduits and/or fluid connectors, and define respective one of a pair of flow loops for the power converters 102.

The fluid driver 144 is configured to circulate liquid coolant through the first flow circuit 140 and/or the second flow circuit 142. In some embodiments, the cooling system 103 includes a pair of fluid drivers 144, including a first fluid driver 144a fluidly coupled to the first flow circuit 140 and a second fluid driver 144b fluidly coupled to the second flow circuit 142. Among other benefits, such an arrangement provides redundancy in the event of loss of power to one of the fluid drivers 144. In other embodiments, the cooling system 103 includes a single fluid driver that is shared between the first flow circuit 140 and the second flow circuit 142. In some embodiments, the fluid driver 144 is a liquid pump, such as a positive displacement pump or a centrifugal pump. In other embodiments, the fluid driver 144 may be another type of pump or fluid displacement device.

The sensor 145 is configured to generate sensor data (e.g., a sensor signal, etc.) indicative of an operating condition of the cooling system 103. In some embodiments, the sensor 145 includes a flow monitoring sensor that is configured to measure a flow parameter associated with the first flow circuit 140 and/or the second flow circuit 142. For example, the sensor may be configured to generate a sensor signal indicative of a fluid blockage of the first flow circuit 140 and/or the second flow circuit 142. The sensor 145 may be a pressure sensor that is configured to measure a static pressure at one or more locations along the first flow circuit 140 or the second flow circuit 142. In other embodiments, the sensor 145 may include a flow rate sensor or a temperature sensor. In yet other embodiments, the sensor 145 may be configured to generate sensor data indicative of an operating condition of one or more power converters 102 or one or more power converter module assemblies 104, such as operating temperature, voltage, etc.

The cooling control module 146 (e.g., a cooling control unit, a cooling control circuit, etc.) is configured to monitor and/or control operation of the cooling system 103. In some embodiments, the cooling control module 146 is configured to control operation of the power converters 102 and/or individual power converter module assemblies 104 based on an operating status of the cooling system 103.

In some embodiments, the cooling control module 146 includes a controller 148 having memory storing machine-readable instructions thereon, and a processor communicably coupled to the memory and configured to execute the machine-readable instructions to control operation of the power converters 102 and/or individual ones of the power converter module assemblies 104.

In the embodiment of FIG. 1, the controller 148 is communicably coupled to the plurality of power converters 102, the plurality of power converter module assemblies 104 (e.g., the power converter module of each power converter module assembly), and the sensor(s) 145. The controller 148 is configured to reduce a power consumption of the plurality of power converters 102 (e.g., each of the power converter module assemblies 104, etc.) in response to sensor data (e.g., a sensor signal, etc.) indicative of a fluid blockage in the first flow circuit 140 and/or the second flow circuit 142. In some embodiments, the controller 148 is configured to reduce a power consumption of the power converters 102 to a non-zero fraction of a rated power of the power converters 102, such as approximately 72% of the rated power, 65% of the rated power, 60% of the rated power, 55% of the rated power, 50% of the rated power, or within a range between and including any two of the foregoing values.

In some embodiments, the controller 148 is also configured to control operation of the fluid driver 144 based on the sensor data. For example, the controller 148 may be configured to deactivate the fluid driver 144 and/or change the flow rate of the fluid driver 144 in response to a sensor signal indicative of a fluid blockage in the first flow circuit 140 and/or the second flow circuit 142.

Notwithstanding the embodiments described above in reference to FIGS. 1-4, FIGS. 5A-5B, and FIG. 6, various modifications and inclusions to those embodiments are contemplated and considered within the scope of the present disclosure.

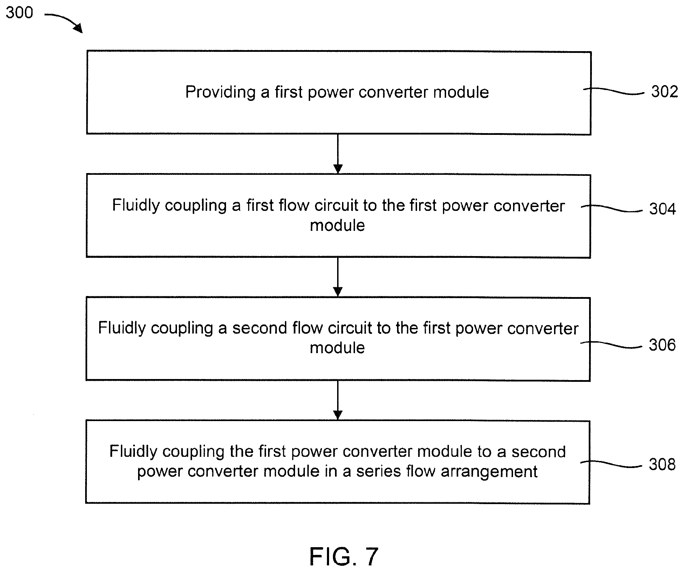

Referring to FIG. 7, a method 300 of making a power converter system is shown, such as any of the power systems described with reference to FIGS. 1-4 and FIGS. 5A-5B, according to an embodiment.

At operation 302, a first power converter module is provided. In some embodiments, operation 302 includes placing the power converter module in a support structure onboard an aircraft or other vehicle. In at least one embodiment, operation 302 includes assembling the first power converter module. In such embodiments, operation 302 may include coupling a microchannel structure to a semiconductor package of the first power converter module; fluidly coupling a first flow manifold to the microchannel structure; and fluidly coupling a second flow manifold to the microchannel structure in a parallel flow arrangement with the first manifold.

At operation 304, a first flow circuit is fluidly coupled to the first power converter module. In some embodiments, operation 304 includes connecting flow conduits (e.g., a first flow loop, etc.) to an inlet and outlet of the first flow manifold. Operation 304 may also include fluidly coupling a fluid driver (e.g., a first fluid driver, etc.) to the first flow manifold.

At operation 306, a second flow circuit is fluidly coupled to the first power converter module. In some embodiments, operation 306 includes connecting flow conduits (e.g., a second flow loop, etc.) to an inlet and outlet of the second flow manifold. Operation 304 may also include fluidly coupling a fluid driver (e.g., a second fluid driver, etc.) to the second flow manifold.

At operation 308, the first power converter module is fluidly coupled to a second power converter module in a series flow arrangement. In some embodiments, operation 308 includes fluidly coupling the first power converter module to a second power converter module having substantially the same structure as the first power converter module. In some embodiments, operation 308 includes fluidly coupling the first flow circuit to the first flow manifold of each of the first power converter module and the second power converter module in series flow arrangement, and fluidly coupling the second flow circuit to the second flow manifold of each of the first power converter module and the second power converter module in series flow arrangement.

As utilized herein with respect to numerical ranges, the terms "approximately," "about," "substantially," and similar terms generally mean +/- 10% of the disclosed values, unless specified otherwise. As utilized herein with respect to structural features (e.g., to describe shape, size, orientation, direction, relative position, etc.), the terms "approximately," "about," "substantially," and similar terms are meant to cover minor variations in structure that may result from, for example, the manufacturing or assembly process and are intended to have a broad meaning in harmony with the common and accepted usage by those of ordinary skill in the art to which the subject matter of this disclosure pertains. Accordingly, these terms should be interpreted as indicating that insubstantial or inconsequential modifications or alterations of the subject matter described and claimed are considered to be within the scope of the disclosure as recited in the appended claims.

The term "coupled" and variations thereof, as used herein, means the joining of two members directly or indirectly to one another. Such joining may be stationary (e.g., permanent or fixed) or moveable (e.g., removable or releasable). Such coupling may be mechanical, electrical, or fluidic.

References herein to the positions of elements (e.g., "top," "bottom," "above," "below") are merely used to describe the orientation of various elements in the FIGURES. It should be noted that the orientation of various elements may differ according to other exemplary embodiments, and that such variations are intended to be encompassed by the present disclosure.

The hardware and data processing components used to implement the various processes, operations, illustrative logics, logical blocks, modules and circuits described in connection with the embodiments disclosed herein may be implemented or performed with a general purpose single- or multi-chip processor, a digital signal processor (DSP), an application specific integrated circuit (ASIC), a field programmable gate array (FPGA), or other programmable logic device, discrete gate or transistor logic, discrete hardware components, or any combination thereof designed to perform the functions described herein. A general purpose processor may be a microprocessor, or, any conventional processor, controller, microcontroller, or state machine. A processor also may be implemented as a combination of computing devices, such as a combination of a DSP and a microprocessor, a plurality of microprocessors, one or more microprocessors in conjunction with a DSP core, or any other such configuration. In some embodiments, particular processes and methods may be performed by circuitry that is specific to a given function. The memory (e.g., memory, memory unit, storage device) may include one or more devices (e.g., RAM, ROM, Flash memory, hard disk storage) for storing data and/or computer code for completing or facilitating the various processes, layers and modules described in the present disclosure. The memory may be or include volatile memory or non-volatile memory, and may include database components, object code components, script components, or any other type of information structure for supporting the various activities and information structures described in the present disclosure. According to an exemplary embodiment, the memory is communicably connected to the processor via a processing circuit and includes computer code for executing (e.g., by the processing circuit or the processor) the one or more processes described herein.

The present disclosure contemplates methods, systems and program products on any machine-readable media for accomplishing various operations. The embodiments of the present disclosure may be implemented using existing computer processors, or by a special purpose computer processor for an appropriate system, incorporated for this or another purpose, or by a hardwired system. Embodiments within the scope of the present disclosure include program products comprising machine-readable media for carrying or having machine-executable instructions or data structures stored thereon. Such machine-readable media can be any available media that can be accessed by a general purpose or special purpose computer or other machine with a processor. By way of example, such machine-readable media can comprise RAM, ROM, EPROM, EEPROM, or other optical disk storage, magnetic disk storage or other magnetic storage devices, or any other medium which can be used to carry or store desired program code in the form of machine-executable instructions or data structures and which can be accessed by a general purpose or special purpose computer or other machine with a processor. Combinations of the above are also included within the scope of machine-readable media. Machine-executable instructions include, for example, instructions and data which cause a general purpose computer, special purpose computer, or special purpose processing machines to perform a certain function or group of functions.

Although the figures and description may illustrate a specific order of method steps, the order of such steps may differ from what is depicted and described, unless specified differently above. Also, two or more steps may be performed concurrently or with partial concurrence, unless specified differently above.

It is important to note that any element disclosed in one embodiment may be incorporated or utilized with any other embodiment disclosed herein. The systems and methods described herein may be embodied in other specific forms without departing from the scope of the claims. The foregoing implementations are illustrative rather than limiting of the described systems and methods.

## Claims

1. A power converter system (100) comprising:
a plurality of power converter module assemblies (104), each power converter module assembly of the plurality of power converter module assemblies including:
a semiconductor package (106) defining a heat transfer surface (120);
a first flow manifold (110) thermally coupled to the heat transfer surface; and
a second flow manifold (112) thermally coupled to the heat transfer surface; and
a cooling system (103), including:
a first flow circuit (140) fluidly coupled in series flow arrangement to the first flow manifold of each of the plurality of power converter module assemblies; and
a second flow circuit (142) fluidly coupled in series flow arrangement to the second flow manifold of each of the plurality of power converter module assemblies.

2. The power converter system of claim 1, wherein each of the plurality of power converter module assemblies further includes a microchannel structure (108), at least one of the first flow manifold or the second flow manifold fluidly coupled to the microchannel structure.

3. The power converter system of claim 1 or 2, wherein the first flow manifold is one of a plurality of first flow manifolds (210) coupled to the heat transfer surface, and wherein the second flow manifold is one of a plurality of second flow manifolds (212) coupled to the heat transfer surface.

4. The power converter system of one of claims 1-3, wherein at least one power converter module assembly further includes a switch (114) on a first side (116) of the semiconductor package, further comprising a microchannel structure (108) disposed on a second side (118) of the semiconductor package, the microchannel structure being centered with respect to the switch, and wherein the first flow manifold is centered with respect to a first half portion (132) of the microchannel structure and the second flow manifold is centered with respect to a second half portion (134) of the microchannel structure that is approximately equal in size to the first half portion.

5. The power converter system of one of claims 1-4, wherein the first flow manifold is centered with respect to a first half portion (132) of the semiconductor package and the second flow manifold is centered with respect to a second half portion (134) of the semiconductor package that is approximately equal in size to the first half portion.

6. A power converter system (100) comprising:
a power converter module assembly (104a) including:
a semiconductor package (106) defining a heat transfer surface (120);
a microchannel structure (108) coupled to the heat transfer surface;
a first flow manifold (110) fluidly coupled to the microchannel structure; and
a second flow manifold (112) fluidly coupled to the microchannel structure in parallel flow arrangement with the first flow manifold;
a first flow circuit (140) fluidly coupled to the first flow manifold; and
a second flow circuit (142) fluidly coupled to the second flow manifold.

7. The power converter system of one of claims 2-6, wherein the first flow manifold and the second flow manifold occupy substantially equal portions of the microchannel structure.

8. The power converter system of one of claims 2-7, wherein the first flow manifold is fluidly isolated from the second flow manifold by the microchannel structure.

9. The power converter system of one of claims 2-8, wherein the microchannel structure defines a plurality of substantially parallel microchannels (126) extending across the heat transfer surface.

10. The power converter system of one of claims 1-9, further comprising:
a sensor (145) configured to generate a signal indicative of a fluid blockage in one of the first flow circuit (140) and the second flow circuit (142); and
a controller (148) communicably coupled the power converter module assembly and the sensor, the controller configured to reduce a power consumption of the power converter module assembly to a non-zero fraction of a rated power of the power converter module assembly based on the signal.

11. The power converter system of one of claims 2-10, wherein the power converter module assembly further includes a switch (114) on a first side (116) of the semiconductor package, wherein the microchannel structure is disposed on a second side (118) of the semiconductor package and is centered with respect to the switch.

12. The power converter system of claim 11, wherein the first flow manifold is centered with respect to a first half portion (132) of the semiconductor package and the second flow manifold is centered with respect to a second half portion (134) of the semiconductor package that is approximately equal in size to the first half portion.

13. A method comprising:
providing a first power converter module assembly (104a), the first power converter module assembly comprising:
a semiconductor package (106);
a microchannel structure (108) coupled to the semiconductor package;
a first flow manifold (110) coupled to the microchannel structure; and
a second flow manifold (112) coupled to the microchannel structure in parallel flow arrangement with the first flow manifold;
fluidly coupling a first flow circuit (140) to the first flow manifold; and
fluidly coupling a second flow circuit (142) to the second flow manifold.

14. The method of claim 13, further comprising fluidly coupling the first power converter module assembly to a second power converter module assembly (104b) having substantially the same structure as the first power converter module assembly and so that the first power converter module assembly and the second power converter module assembly are arranged in series flow arrangement.

15. The method of claim 14, wherein fluidly coupling the first power converter module assembly to the second power converter module assembly comprises:
fluidly coupling the first flow circuit to the first flow manifold of each of the first power converter module assembly and the second power converter module assembly in series flow arrangement; and
fluidly coupling the second flow circuit to the second flow manifold of each of the first power converter module assembly and the second power converter module assembly in series flow arrangement.
